# EUROPEAN PATENT APPLICATION

(11) **EP 1 887 830 A2**
(43) Date of publication of application: **13.02.2008**
(21) Application number: 07015914.0
(22) Date of filing: 13.08.2007
(51) Int. Cl.: H04R 3/00

(54) **Protection circuit and load current detection circuit**

(30) Priority: 11.08.2006 JP 2006220286
(71) Applicant: Flying Mole Corporation, Hamamatsu-shi, Shizuoka-ken (JP)
(72) Inventor: Miyake, Yoshiro, Hamamatsu-shi Shizuoka-ken (JP); Ogawa, Hiroshi, Hamamatsu-shi Shizuoka-ken (JP); Yokoyama, Kenji, Mitaka-shi Tokyo (JP)
(74) Representative: Grünecker, Kinkeldey, Stockmair & Schwanhäusser Anwaltssozietät

(57) **Abstract**

The present invention provides a small and inexpensive protection circuit capable of protecting a protection target with which a coil is connected in series from over-current and a load current detection circuit suitable for such a protection circuit. A load current detection circuitaccordingtothe presentinvention detects load current of a load with which a coil is connected in series. In this circuit, a series circuit of a resistor and a capacitor is connected in parallel with the coil, and voltage between both ends of the capacitor is derived as detection voltage reflecting load current of the load, and values of the respective elements are selected so that L1/R1=C2 · R2 is met when an inductance of the coil is L1, a resistance value of a resistance component in the coil is R1, a resistance value of the resistor in the series circuit is R2, and a capacitance of the capacitor in the series circuit is C2. The protection circuit according to the present invention utilizes the load current detection circuit according to the present invention.

## Description

### BACKGROUND OF THE INVENTION

### 1. Technical Field Relating to the Invention

The present invention relates to a protection circuit and a load current detection circuit applicable to an over-current protection circuit for a digital audio amplifier, for example.

### 2. Description of Related Art

Conventionally, such an over-current protection circuit for an audio amplifier is described in Japanese Patent Laid-Open No. 9-270652, for example. In the conventional art described in this publication, a power source supplied to a signal amplifier portion for amplifying signals to a load is turned off at the time of detecting the over-current flowing into the load such as loudspeakers, etc., for example, thereby protecting the load from the over-current flowing therein. Also, to detect load current, a detection resistor whose value is smaller than the load' s is provided in series with the load, and the voltage generated between its both ends, which is voltage proportionality constant times as large as the load current, is derived

However, in case of the conventional protection circuit, since the electric power source of the signal amplifier portion which amplifies the signal to the load is shut off, no signals are supplied to the load at the time of an over-current . For example, in the case of supplying audio signals to the load, an output generating sound is shut off, which therefore provides uncomfortable feeling to a listener.

Also, in cases of applying such the over-current protection circuit as mentioned above to a converter for converting A/C electric power into D/C electric power, or an inverter for inverting D/C electric power into A/C electric power, for example, when the electric power to the load becomes excessive, the supply of electric power to the load is shut off, and therefore it brings about cases where the load (for example, a processing circuit) cannot execute any processing therein.

Further, under the conditionwhere the current flowing into the load (loudspeaker) is derived by converting the resistance into the voltage, the current is large, and much heat is generated at the detection resistor. Thus, in cases of applying the protection circuit configured as above to a digital power amplifier whose miniaturization is a trend, the detection resistor element is inevitably large in size, and the cost is undesirably high. Also, there exists a circuit configuration in which input voltage is supplied to the load via a low-pass filter. In such a circuit, a coil constituting the low-pass filter is connected in series with the load. In this case, there is a problem of how the load current is derived without impacting the low-pass filter, and the protection circuit may be complex.

### SUMMARY OF THE INVENTION

The present invention is accomplished by taking such the problems as mentioned above into consideration thereof, and an object thereof is to provide a small and inexpensive protection circuit capable of protecting a protection target from the over-current or the like and a load current detection circuit suitable for such a protection circuit.

A first aspect of the present invention is a load current detection circuit for detecting load current of a load with which a coil is connected in series, wherein a series circuit of a resistor and a capacitor is connected in parallel with said coil, and voltage between both ends of said capacitor is derived as detection voltage detecting load current of said load, and wherein values of said respective elements are selected so that L1/R1=C2 • R2 is met when an inductance of said coil is L1, a resistance value of a resistance component in said coil is R1, a resistance value of said resistor in said series circuit is R2, and a capacitance of said capacitor in said series circuit is C2.

A second aspect of the present invention is a protection circuit for regarding a load with which a coil is connected in series as a protection target circuit and for protecting said protection target circuit from over-current, comprising the load current detection circuit of the first aspect of the present invention as a current detecting portion for detecting current flowing in said protection target circuit in form of voltage thereof.

With the present invention, it is possible to provide a small and inexpensive protection circuit capable of protecting a protection target from the over-current or the like and a load current detection circuit.

### BRIEF DESCRIPTION OF DRAWINGS

Those and other objects, features and advantages of the present invention will become more readily apparent from the following detailed description when taken in conjunction with the accompanying drawings wherein:
Fig. 1 is a block diagram showing the structures of a protection circuit according to a first embodiment of the present invention;
Fig. 2 is a circuit diagram explaining detection principles of a load current detection circuit according to the first embodiment of the present invention;
Fig. 3 is a circuit diagram showing the structures of a protection circuit according to a second embodiment of the present invention;
Figs. 4A to 4H show signal waveforms at various portions within the protection circuit according to the second embodiment of the present invention;
Fig. 5 is a view explaining influences affected by the gain of an operational amplifier within the protection circuit of the second embodiment;
Fig. 6 is an explanatory view showing a foldback current limiting characteristic within the protection circuit of the second embodiment, when the load short-circuits;
Fig. 7 is a circuit diagram showing a modified embodiment (1^{st}) of the second embodiment;
Figs. 8A and 8B are views explaining a phase relationship between input/output signals of an amplifier, upon which a modified embodiment (2^{nd}) of the second embodiment makes presumption; and
Fig. 9 is a circuit diagram showing the modified embodiment (2^{nd}) of the second embodiment.

### DETAILED DESCRIPTION OF THE PREFERRED EMBODIMENTS

### (A) Fist Embodiment

Hereinafter, explanation will be made on a first embodiment of a protection circuit and a load current detection circuit, according to the present invention. The protection circuit of the fist embodiment is for protection of a load (such as loudspeakers, for example), from the over-current, supplied with an output of a digital audio amplifier.

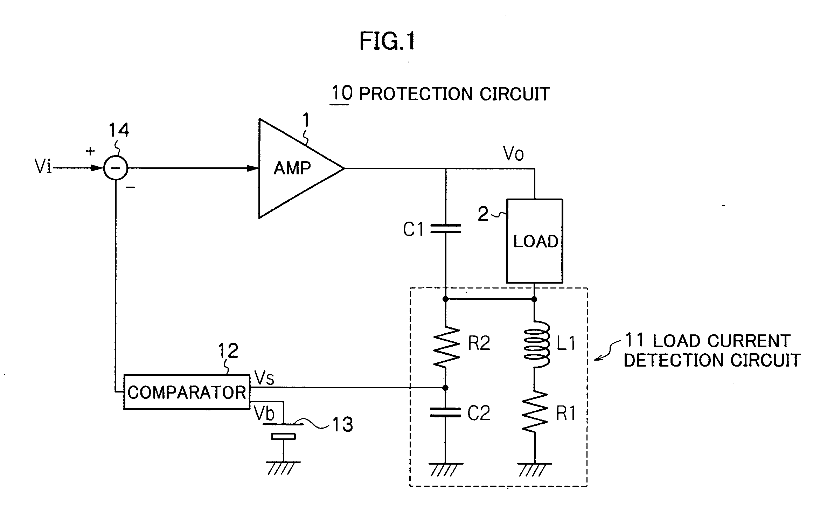

Fig. 1 is a block diagram showing the structures of the protection circuit and the load current detection circuit according to the first embodiment.

In Fig. 1, the protection circuit 10 of the first embodiment is provided, in relation to a digital audio amplifier 1, for supplying a voltage signal Vo obtained through amplification of an input voltage signal Vi to a load (for example, loudspeakers) 2. Herein, since the output from the digital audio amplifier 1 is a PWM signal (pulse-width modulation signal), a low-pass filter (LPF) consisting of a capacitor C1 in parallel with the load 2 and a coil L1 in series with the load 2 is provided. It is noted that a resistor R1 represents a resistance component of the coil L1.

The protection circuit 10 of the first embodiment includes a load current detection circuit 11, a comparator portion 12, a reference voltage portion 13, and an adder portion 14.

The load current detection circuit 11 obtains voltage (i.e., detection voltage) Vs reflecting current flowing through the load 2, to input it into the comparator portion 12. The load current detection circuit 11 is constituted by a series circuit of the coil L1, which is an element of the aforementioned low-pass filter, and the resistor R1, and a series circuit of a resistor R2 and a capacitor C2 provided in parallel with the series circuit. Herein, among the values of the respective elements constituting the load current detection circuit 11, the relationship of L1/R1=C2 R2 (hereinafter referred to as Equation (1)) exists. The load current detection circuit 11 inputs voltage at a junction point of the resistor R2 and the capacitor C2 to the comparator portion 12 as the detection voltage Vs reflecting current flowing through the load 2.

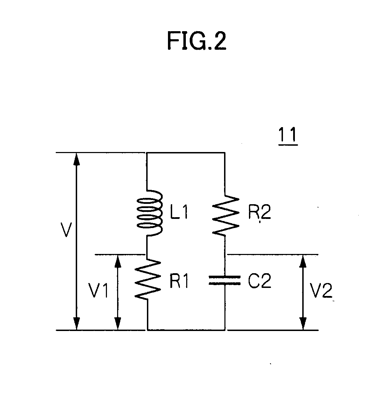

Referring to Fig. 2, the fact that the voltage at the junction point of the resistor R2 and the capacitor C2 can be utilized as the detection voltage Vs for the load current will be explained.

Voltage between both ends (voltage drop) V1 at the resistor R1 as a resistance component of the coil L1 is one that ref lects current flowing through the load 2. However, since the resistor R1 is a resistance component of the coil L1, it cannot obtain its voltage V1 . Thus, the series circuit of the resistor R2 and the capacitor C2 is provided so that voltage V2 (=V1) equivalent to this voltage V1 can be taken out.

Applied voltage to the parallel circuit consisting of the series circuit of the coil L1 and the resistor R1 and the series circuit of the resistor R2 and the capacitor C2 is called V. In this case, the voltage between both ends (voltage drop) V1 at the resistor R1 is expressed as V1=V/ (1+j • ω • (L1/R1)) (hereinafter referred to as Equation (2)) while the voltage V2 at the junctionpoint of the resistor R2 and the capacitor C2 is expressed as V2=V/(1+j • ω • C2 R2) (hereinafter referred to as Equation (3)). In a case where the aforementioned relationship of Equation (1) is established among the values of the respective elements constituting the load current detection circuit 11, the two voltage values V1 and V2 expressed as Equations (2) and (3) are equivalent, and thus the voltage V2 at the junction point of the resistor R2 and the capacitor C2 can be utilized as the detection voltage Vs for the load current.

The reference voltage portion 13 provides reference voltage Vb to the comparator portion 12. This reference voltage Vb is selected to a value that can determine on whether current is the over-current or not.

The comparator portion 12 compares the detection voltage Vs and the reference voltage Vb, and when the detection voltage Vs is larger than the reference voltage Vb, it outputs difference voltage Vs-Vb, or protection voltage Vr obtained by applying a simply increasing function onto that difference voltage, while it outputs 0 when the detection voltage Vs is equal or smaller than the reference voltage Vb.

The adder portion 14 subtracts the protection voltage Vr or 0, outputted by the comparator portion 12, from the input voltage signal Vi, thereby to supply it to the amplifier 1.

When current flowing through the load 2 is not the over-current, the detection voltage Vs at the time of detecting the load current is also smaller than the reference voltage Vb, therefore the comparator portion 12 outputs 0. For the reason, even if the adder portion 14 subtracts the output of the comparator portion 12 from the input voltage signal Vi, an output from the adder portion 14 remains the input voltage signal Vi as it is, and therefore each portion operates without conducting operations for over-current protection.

On the contrary, when over-current flows through the load 2, then the detection voltage Vs obtained by converting the load current into voltage comes to be larger than the reference voltage Vb, and therefore the protection voltage Vr is outputted from the comparator portion 12, depending on the difference between the detection voltage Vs and the reference voltage Vb. For that reason, the adder portion 14 subtracts the protection voltage Vr of the comparator portion 12 from the input voltage signal Vi, and inputs a voltage signal Vi-Vr after subtraction to the amplifier 1. This protects the amplifier 1 and the load 2.

Herein, the larger the input voltage signal Vi, the greater the degree of the over-current, and the detection voltage Vs is almost linear to the input voltage signal Vi. Also, the protection voltage Vr is the difference voltage Vs-Vb between the detection voltage Vs and the reference voltage Vb, or the voltage obtained by applying a simply increasing function onto the difference voltage Vs-Vb. As a result, the voltage signal Vi-Vr after the subtraction mentioned above, when over-current protection functions, has a value being almost constant. In other words, clopping the voltage portion larger than a predetermined level, with respect to such over voltage of the input voltage signal Vi, results in the voltage signal Vi-Vr after the subtraction.

According to the first embodiment, the coil of the low-pass filter consisting of the coil L1 and the resistor R1 in consideration of a resistance component is provided with the series circuit of the resistor R2 and the capacitor C2 whose values have been selected as shown in Equation (1) so that the detection voltage for the load current is obtained. Thus, even if the low-pass filter exists, it is possible to obtain the detection voltage reflecting the load current and to execute the over-current protection.

Also, since the resistor R1 is a resistance component of the coil L1, it is possible to drastically eliminate heat generated excessively for detection of the load current. Also, since the impedance is high at the series circuit of the resistor R2 and the capacitor C2, it is possible to detect current flowing through the load 2 from both ends of C2 as voltage constant times as large as current flowing through the coil L1, which is in series with the load 2, at the same time of eliminating heat generated. Thus, it is possible to provide a small and inexpensive protection circuit 10.

Herein, as apparent from Equation (3), if the value of the capacitor C2 is made to be smaller, the detection voltage Vs (=V2) can be extended when it is taken out (the dynamic range can be extended), which makes the reference voltage Vb larger. Thus, it is possible to let the comparator portion 12 generally constituted by an operational amplifier easy to make and produce few errors.

Also, according to the first embodiment, it is possible to execute the over-current protection through clipping of the input voltage signal, and also to supply the voltage signal to the load 2 continuously.

Even when the over-current is generated in case where the input voltage signal is the audio signal, the output for generating sounds is not be shut off, as in the conventional protection circuit, and therefore according to the first embodiment, it is possible to continue to provide the output for generating sounds while protecting it from the over-current.

### (B) Second Embodiment

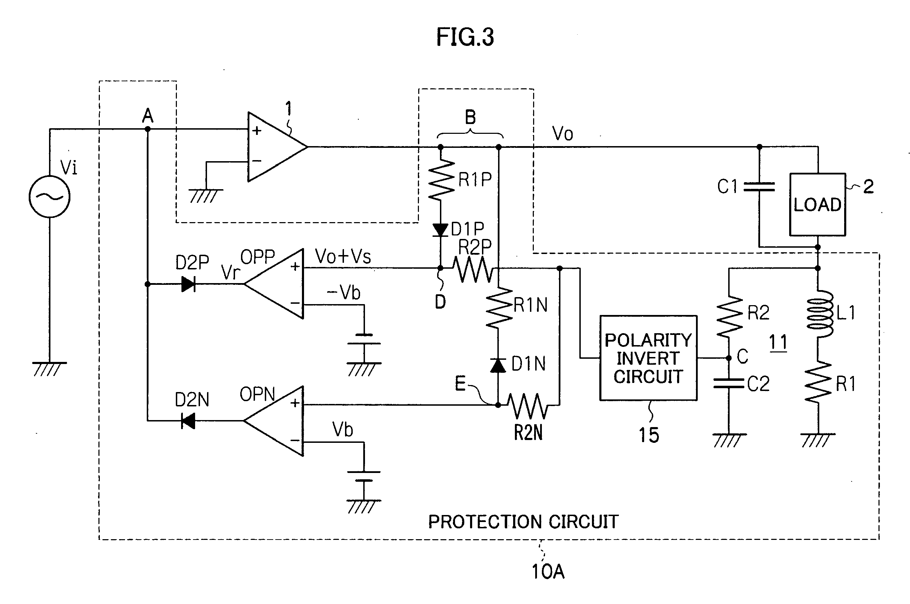

Next, explanation will be made on a second embodiment of the protection circuit according to the present invention, by referring to the drawings. The protection circuit of the second embodiment is shown in more details about the constructions thereof, comparing to that of the first embodiment. Fig. 3 is a circuit diagram showing the structures of the protection circuit according to the second embodiment.

The protection circuit 10A according to the second embodiment comprises a first protection circuit for functioning when the input voltage signal Vi is positive, and a second protection circuit for functioning when the input voltage signal Vi is negative. In Fig. 3, each of elements of the first protection circuit is shown by a reference numeral affixed with P at the end thereof, while each of elements of the second protection circuit by a reference numeral affixed with N at the end thereof, except for a load current detection circuit 11. Thus, the second protection circuit is also similar to the first protection circuit, except for the polarity thereof.

In Fig. 3, the load 2 onto which the voltage signal Vo outputted from the digital audio amplifier 1 and filtered by the low-pass filter is applied is grounded through the load current detection circuit 11.

Between a point B on the supply line of the voltage signal Vo to the load 2 and a junction point C of the resistor R2 and the capacitor C2 in the load current detection circuit 11, there are connected a resistor R1P, a diode D1P (directing a cathode thereof to the side of resistor R1P), and a resistor R2P, sequentially, in that order from the point B. A junction point D of an anode of the diode D1P and the resistor R2P is connected to a non-reverse input terminal (i.e., a plus (+) input terminal) of the operational amplifier OPP. To a reverse input terminal (i.e., a minus (-) input terminal) of the operational amplifier OPP is connected a reference negative voltage -Vb.

An output terminal of the operational amplifier OPP is connected to a cathode of the diode P2P, while an anode of this diode D2P is connected to the junction point A on a route starting from a signal source to the non-reverse input terminal of the digital audio amplifier 1.

Between the aforementioned point B and the aforementioned point C, there are connected a resistor R1N, a diode D1N (directing a cathode thereof to the side of resistor R1N), and a resistor R2N, sequentially, in that order from the point B. A junction point E of a cathode of the diode D1N and the resistor R2N is connected to a non-reverse input terminal (i.e., a plus (+) input terminal) of an operational amplifier OPN. To a reverse input terminal (i.e., a minus (-) input terminal) of the operational amplifier OPN is connected a reference positive voltage Vb. An output terminal of the operational amplifier OPN is connected to of an anode the diode D2N, while a cathode of this diode D2N is also connected the junction point A on a route starting from the signal source to the non-reverse input terminal of the digital audio amplifier 1.

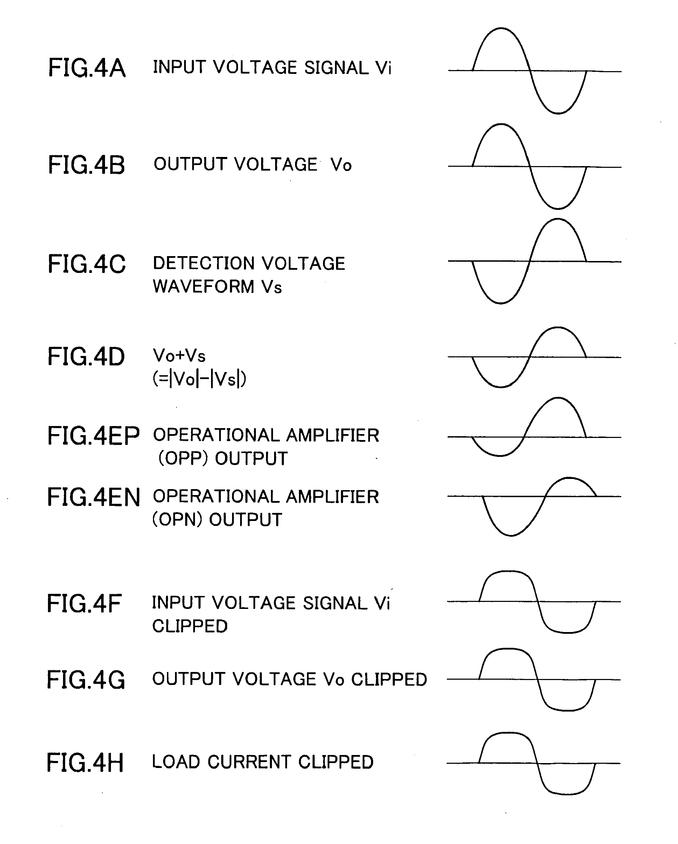

Next, explanation will be made on the operations within the protection circuit 10A having such structures as mentioned above, according to the second embodiment, by referring to signal waveforms shown in Figs. 4A to 4H.

The input voltage signal Vi from the signal-generating source shown in Fig. 4A is amplified by means of the digital audio amplifier 1 and is filtered by means of the low-pass filter, and it comes to the output voltage signal Vo to the load 2, as shown in Fig. 4B. Applying this output voltage signal Vo thereon, current flowing through the load 2 is converted into the detection voltage signal Vs, as shown in Fig. 4C, by means of the load current detection circuit 11. This second embodiment is for a case where the current flowing through the load 2 is oppositely phased in a relationship to the output voltage signal Vo, and for that reason, the detection voltage signal Vs is also oppositely phased in the relationship to the output voltage signal Vo.

Since the point B is connected to the non-reverse input terminal of the operational amplifier OPP through the resistor R1P and the diode D1P, and the point C is connected to the non-reverse input terminal of the operational amplifier OPP through the resistor R2, an addition value (Vo+Vs) of the output voltage signal Vo and the detection voltage signal Vs are inputted to the non-reverse input terminal of the operational amplifier OPP. However, as mentioned above, the detection voltage signal Vs is oppositely phased in the relationship to the output voltage signal Vo and they are in such relationship, i.e., |Vo|<|Vs| under the situation where the over-current occurs. Therefore, when the output voltage signal Vo is within a positive range, the addition value (Vo+Vs) has a value |Vo|-|Vs|, as shown in Fig. 4D, i.e., a minus value.

Meanwhile, by inputting an addition value (Vo+Vs) of the output voltage signal Vo and the detection voltage signal Vs to the non-reverse input terminal of the operational amplifier OPP, "foldback current limiting characteristics" to be described later appear between the load voltage and the load current.

Since the reference negative voltage (-Vb) is inputted to the reversed input terminal of the operational amplifier OPP, the output voltage of the operational amplifier OPP is Vo+Vs- (-Vb) = |Vo| - |Vs|+Vb. Under the situation where the over-current occurs, this value |Vo|-|Vs|+Vb also takes a negative value, as shown in Fig. 4(EP). However, under the situation where no over-current occurs, this value |Vo|-|Vs|+Vb also takes a positive value.

When the output voltage from the operational amplifier OPP is positive, due to existence of the diode D2P, to the junction point A is transmitted no output voltage from the operational amplifier OPP.

On the other hand, since the negative output from the operational amplifier OPP is overlapped onto the positive input voltage signal Vi at the junction point A, the large value of the positive input voltage signal Vi is clipped.

In the above, the explanation is given about the operation of the first protection circuit for functioning when the input voltage signal Vi is positive. However, the second protection circuit for functioning when the input voltage signal Vi is negative performs the operations contrast to that of the first protection circuit. Fig. 4 (EN) shows the output from the operational amplifier OPP, |Vo|-|Vs|-Vb, when the over-current flows, and since this is overlapped onto the negative input voltage signal Vi, the negative large value of the negative input voltage signal Vi is clipped.

Fig. 4F shows the input voltage signal Vi after clipping the positive and negative large values of such input voltage signal Vi causing the over-current. Since this clipped input voltage signal Vi is inputted into the digital audio amplifier 1, the voltage signal Vo to the load 2 also comes to be clipped on the large values thereof, as shown in Fig. 4G, and the current flowing into the load 2 also comes to be clipped on the large values thereof, as shown in Fig. 4H. Thus, the over-current is suppressed, and the load 2 is protected from the over-current and/or the voltage Vo applied thereon.

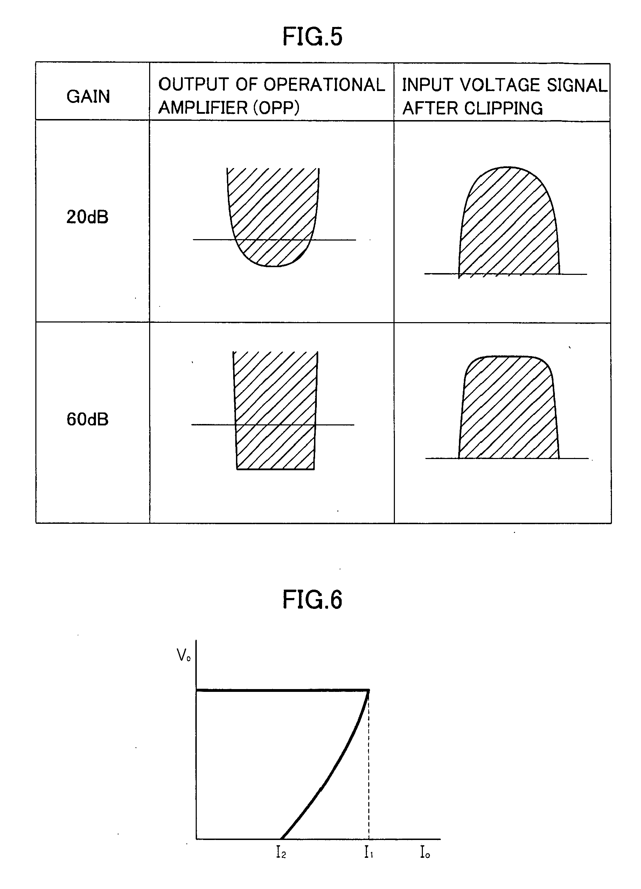

Fig. 5 shows the signal waveforms of the output voltage waveforms |Vo|-|Vs|+Vb from the operational amplifier OPP, and the input voltage signals Vi clipped, in case when the gain of the operational amplifier OPP is 20dB and 60dB, respectively. As apparent from Fig. 5, when changing the gain of the operational amplifier OPP, the roundness is changed on the output voltage waveforms |Vo|-|Vs|+Vb from the operational amplifier OPP, and an amount of pull-in into the operational amplifier OPP is also changed, and further the roundness is also changed on the input voltage signal Vi after the clipping thereon. Thus, through selection on the gain of the operational amplifiers OPP (and OPN), it is possible to adjust the clipping function.

Also, in the protection circuit according to the second embodiment, since the input voltage into the non-reverse input terminal of the operational amplifier OPP is changed by Vs when the load 2 is short-circuited, the clipping function operates on a small value of short-circuit current. Accompanying with this, short-circuiting function further decreases, so that the condition that the clipping function works much more is repeated. Fig. 6 shows foldback current limiting characteristics between the voltage Vo applied onto the load and the loadcurrent Io, when the load is short-circuited. Making such foldback current limiting characteristics can finally suppress the short-circuited current down to I2, thereby reducing the load applied upon the digital audio amplifier 1 when the load is short-circuited.

With the second embodiment, it is possible to reduce the load of the amplifier provided at a front stage of the load, while suppressing the short-circuiting current to be small when the load is short-circuited, in addition to the similar effect to that in the first embodiment.

### (C) Other Embodiments

The technical concept of the present invention should not be restricted only to such the structures of the embodimentsasmentioned above,andthefollowing variations of the embodiments can be listed up, which will be shown below.

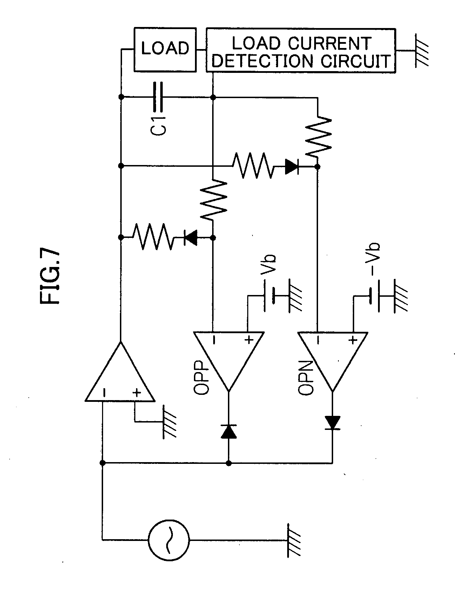

In the second embodiment, the reference voltage is inputted to the reverse input terminals of the operational amplifiers OPP and OPN. However, as shown in Fig. 7, while the reference voltages opposite in the polarity (i.e., positive and negative) to those in the second embodiment are inputted to the non-reverse input terminals of the operational amplifiers OPP and OPN, signals may be inputted to the reverse input terminals of the operational amplifiers OPP and OPN. In Fig.7, the load current detection circuit includes a polarity invert circuit (see Fig. 3).

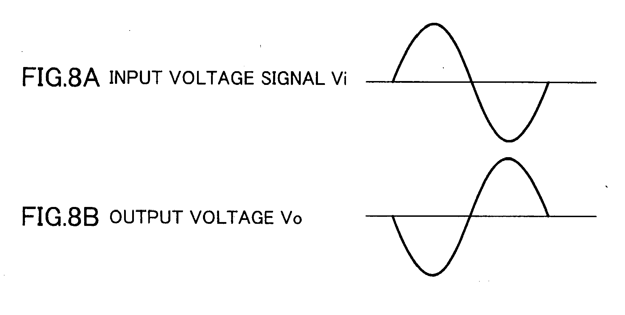

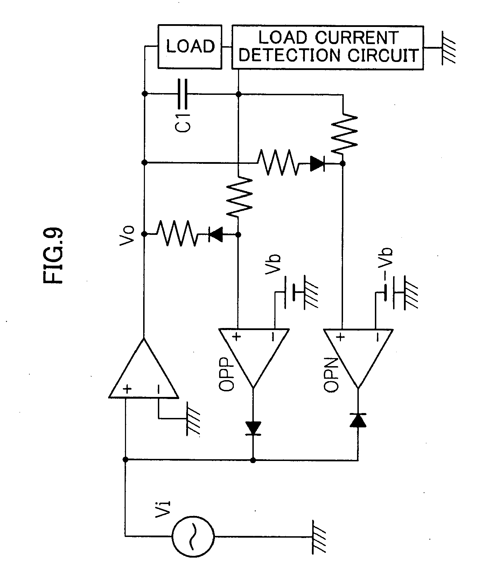

Also, in the second embodiment mentioned above, the input voltage signal Vi to the amplifier 1 and the output voltage signal Vo to the load 2 are same in the phase. However, the present invention can be applied to the case where the input voltage signal Vi to the amplifier 1 and the output voltage signal Vo to the load 2 are oppositely phased, as shown in Figs. 8A and 8B. Fig. 9 shows an example of the structures of the protection circuit in case of opposite phase thereof, as mentioned above, wherein the polarity (i.e., positive and negative) of the reference voltages to the non-reverse input terminals of the operational amplifiers OPP and OPN is reversed to that of the second embodiment, and also the directions of the diodes D1P, D1N, D2P, and D2N are reversed to those of the second embodiment. In Fig.7, the load current detection circuit includes the polarity invert circuit (see Fig. 3).

In the various embodiments mentioned above, there are shown protection circuits intended to be applied to a system which supplies the audio signal (i.e., the voltage signal) from the audio amplifier to the loudspeakers; however, the protection circuit according to the present invention may be also applied where the power source from an electric power source circuit is supplied to the load.

Also, the load current detection circuit explained in the above embodiments can be applied to a protection circuit in which a current route to the load is shut off.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. A load current detection circuit for detecting load current of a load with which a coil is connected in series,
wherein a series circuit of a resistor and a capacitor is connected in parallel with said coil, and voltage between both ends of said capacitor is derived as detection voltage detecting load current of said load, and
wherein values of said respective elements are selected so that L1/R1=C2 R2 is met when an inductance of said coil is L1, a resistance value of a resistance component in said coil is R1, a resistance value of said resistor in said series circuit is R2, and a capacitance of said capacitor in said series circuit is C2.

2. A protection circuit comprising a protection target circuit for regarding a load with which a coil is connected in series as a protection target, a current detecting portion for detecting current flowing in said protection target circuit in form of voltage thereof, and a protecting portion for protecting said protection target circuit from over-current based on detection voltage of said current detecting portion,
wherein in said current detecting portion,
a series circuit of a resistor and a capacitor is connected in parallel with said coil, and voltage between both ends of said capacitor is derived as detection voltage detecting load current of said load, and
values of said respective elements are selected so that L1/R1=C2 • R2 is met when an inductance of said coil is L1, a resistance value of a resistance component in said coil is R1, a resistance value of said resistor in said series circuit is R2, and a capacitance of said capacitor in said series circuit is C2.

3. The protection circuit according to claim 2, wherein said protecting portion comprises:
a comparing portion for comparing the voltage detected within said current detection portion, or a difference between the detected voltage and input voltage into said protection target circuit, with a reference voltage, thereby to output a comparison result; and
a clipping portion for clipping input voltage direct to said protection target circuit, or voltage before being amplified to be input voltage into said protection target circuit by amplification, when the comparison result indicates that current flowing through said protection target circuit is over-current.

4. The protection circuit according to claim 3, wherein said comparing portion compares the difference between the detected voltage and the input voltage to said protection target circuit with the reference voltage, and when said protection target circuit short-circuits, said detected voltage is applied as a target to be compared with said reference voltage, while a characteristic between circuit current and input voltage is foldback current limiting characteristics when said protection target circuit short-circuits.

5. The protection circuit according to claim 2, wherein said coil connected in series with said load constitutes a low-pass filter together with said capacitor connected in parallel with said load.
